# EUROPEAN PATENT SPECIFICATION

(11) **EP 3 893 089 B1**
(45) Date of publication and mention of the grant of the patent: **31.07.2024**
(21) Application number: 20168973.4
(22) Date of filing: 09.04.2020
(51) Int. Cl.: G06F 3/01

(54) **A MULTI-LEVEL HAPTIC FEEDBACK TRANSDUCER, AND A MULTI-LEVEL HAPTIC FEEDBACK TRANSDUCER FOR A HAPTIC FEEDBACK INTERFACE**
WANDLER VON MEHRSTUFIGER HAPTISCHER RÜCKMELDUNG UND WANDLER VON MEHRSTUFIGER HAPTISCHER RÜCKMELDUNG FÜR EINE SCHNITTSTELLE FÜR HAPTISCHE RÜCKMELDUNG
TRANSDUCTEUR DE RÉTROACTION HAPTIQUE À PLUSIEURS NIVEAUX ET TRANSDUCTEUR DE RÉTROACTION HAPTIQUE À PLUSIEURS NIVEAUX POUR UNE INTERFACE DE RÉTROACTION HAPTIQUE

(43) Date of publication of application: 13.10.2021
(73) Proprietor: Robert Bosch GmbH, 70442 Stuttgart (DE)
(72) Inventor: Jeon, Jin Han, Singapore 558962 (SG); So, Yong Heng, Singapur 564596 (SG)

(56) References cited:
- EP-A1- 3 620 895
- US-A1- 2009 002 328
- US-A1- 2017 068 318
- US-A1- 2020 103 966

## Description

### TECHNICAL FIELD

The present disclosure relates to a multi-level haptic feedback transducer, and a multi-level haptic feedback transducer for a haptic feedback interface. The present invention further relates to a multi-level haptic feedback interface including an electrical driving circuit.

### BACKGROUND

There is an increasing trend of haptic applications for hand-held touch sensitive interfaces such as consumer electronics, and customizable dashboards and screens for automotive applications. Haptic feedback recreates a tactile sensation in a user interface device by delivering either mechanical forces, pressures or vibrations to convey information to a user. In particular, a haptic actuator is the main component of a haptic system that provides mechanical actuation to deliver haptic perception to a user.

US 2017/068318 A1 discloses an electronic device, comprising a housing, a display mounted in the housing and a tactile output device. A flexible polymer layer is deformed to produce tactile output for a user by using an electroactive polymer. It is also disclosed that the tactile output device may have fluid control structures that can be used to deform portions of the flexible polymer layer.

EP 3 620 895 A1 discloses a reversible actuator comprising an actuator substrate comprising an electroactive layer in contact with first and second electrodes, the electroactive layer being configured to change shape in response to an electrical signal applied to the electrodes.

US 2009/002328 A1 discloses a method and apparatus of actuator mechanisms for a multi-touch tactile touch panel. The tactile touch panel includes an electrical insulated layer and a tactile layer. The tactile layer includes a grid or an array of piezo haptic cells.

Today's haptic touch interfaces are mostly featured with vibrational haptic feedback driven by inertia-type actuators such as Eccentric Rotating Mass (ERM) and Linear Resonant Actuator (LRA). These actuators have several limitations particularly of bulky size, lack of realistic feedback and complex mechanical design. These actuators also do not provide static forces or morphing deformations that are required for hand-held touch interfaces. Piezoceramic based actuators based on vibrational haptic feedback are also used in consumer electronics. However, the lack of physical large strain responses and realistic haptic feedback in these actuators limits further deployment of such actuators for hand-held touch sensitive interfaces.

Therefore, there is a need for improved haptic actuators, in particular haptic actuators with multi-level haptic feedback modulation.

### SUMMARY

It is therefore an object of the invention to provide an improved multi-level haptic feedback transducer. It is also an object of the invention to provide a haptic feedback interface including the multi-level haptic feedback transducer.

Various embodiments may provide a haptic feedback transducer. The haptic feedback transducer may include an electroactive material (EAM) membrane which may be disposed on a substrate. The EAM membrane may include an EAM layer which may be configured to provide a mechanical response in response to an electrical driving signal. The haptic feedback transducer may further include an air pump which may be configured to control a pressure of a gas. The air pump may be configured to apply the pressure of the gas to a side of the EAM membrane which may be facing the substrate.

Various embodiment may provide a haptic feedback interface which may comprise one haptic feedback transducer, or two or more haptic feedback transducers. The haptic feedback transducers on the haptic feedback interface may share a common substrate.

Various embodiments may provide a haptic feedback interface which may include an electrical driving circuit. The electrical driving circuit may be configured to drive the haptic feedback transducers, and may provide a first EAM electrical driving signal to the EAM layer. The electrical driving circuit may be further configured to provide a first air pump electrical driving signal to the air pump.

### BRIEF DESCRIPTION OF THE DRAWINGS

The invention will be better understood with reference to the detailed description when considered in conjunction with the non-limiting examples and the accompanying drawings, in which:
- FIG. 1 shows a schematic illustration of a haptic feedback transducer 10 according to various embodiments, including an air pump 14, an EAM membrane 11 including an EAM layer 12 disposed on a substrate 13, and an elastic cover layer 18 disposed on the EAM membrane 11;
- FIG. 2A and 2B show a schematic illustration of the working mechanism of a haptic feedback transducer 10, in accordance with various embodiments;
- FIG. 3 shows a schematic illustration of a haptic feedback transducer 30 according to various embodiments, wherein the air pump 14 includes a stack of micro-blowers 16;
- FIG. 4 shows a schematic illustration of a haptic feedback transducer 40 according to various embodiments, which further includes a centerpiece 17 superposed on the EAM layer 12;
- FIG. 5A and 5B show a schematic illustration of the working mechanism of a haptic feedback transducer 40, in accordance with various embodiments;
- FIG. 6 shows a schematic illustration of a top-view of the EAM layer 12 of the haptic feedback transducer 10, in accordance with various embodiments;
- FIG. 7A and 7B show schematic illustrations of a top-view and a cross-section view of the EAM layer 12 of the haptic feedback transducer 10, wherein the EAM layer 12 includes slits 72 provided as through openings, or recesses 73 in a caved configuration, along a direction perpendicular to a top surface of the EAM layer 12, in accordance with various embodiments;
- FIG. 8A shows a schematic illustration of a cross-section view of the EAM layer 12 of the haptic feedback transducer 10 according to various embodiments, wherein a thickness of the EAM layer 12 decreases from an outer portion of the EAM layer 64 to an inner portion of the EAM layer 65;
- FIG. 8B shows a schematic illustration of a top-view of the EAM layer 12 of the haptic feedback transducer 10 according to various embodiments, which further includes an open window 81;
- FIGS. 9A and 9B show schematic illustrations of the haptic feedback transducer 10 according to various embodiments, wherein the EAM layer 12 is mechanically attached to the substrate 13 by a fastener 90;
- FIG. 10 shows a schematic illustration of a haptic feedback interface 100 according to various embodiments, which further includes a plurality of haptic feedback transducers 10;
- FIG. 11 shows a schematic illustration of a haptic feedback interface 110 according to various embodiments, which further includes air channels 112, valves 113, and an additional one or more haptic feedback transducers which are air pump free 111;
- FIG. 12A shows a graph illustrating the force generated from the air pump 14 without the actuation of the EAM layer 12; FIG. 12B shows a graph illustrating the force generated from the air pump 14 in conjunction with the actuation of the EAM layer 12, in accordance with various embodiments; and
- FIG. 13 shows a graph illustrating the various multi-level feedback forces generated by the air pump 14 and/or the EAM layer 12, in accordance with various embodiments.

### DETAILED DESCRIPTION

The following detailed description refers to the accompanying drawings that show, by way of illustration, specific details and embodiments in which the disclosure may be practiced. These embodiments are described in sufficient detail to enable those skilled in the art to practice the disclosure. Other embodiments may be utilized and structural, and logical changes may be made without departing from the scope of the disclosure. The various embodiments are not necessarily mutually exclusive, as some embodiments can be combined with one or more other embodiments to form new embodiments.

Features that are described in the context of an embodiment may correspondingly be applicable to the same or similar features in the other embodiments. Features that are described in the context of an embodiment may correspondingly be applicable to the other embodiments, even if not explicitly described in these other embodiments. Furthermore, additions and/or combinations and/or alternatives as described for a feature in the context of an embodiment may correspondingly be applicable to the same or similar feature in the other embodiments.

The disclosure illustratively described herein may suitably be practiced in the absence of any element or elements, limitation or limitations, not specifically disclosed herein. Thus, for example, the terms "comprising", "including," containing", etc. shall be read expansively and without limitation. The word "comprise" or variations such as "comprises" or "comprising" will accordingly be understood to imply the inclusion of a stated integer or groups of integers but not the exclusion of any other integer or group of integers. Additionally, the terms and expressions employed herein have been used as terms of description and not of limitation, and there is no intention in the use of such terms and expressions of excluding any equivalents of the features shown and described or portions thereof, but it is recognized that various modifications are possible within the scope of the disclosure. Thus, it should be understood that although the present disclosure has been specifically disclosed by exemplary embodiments and optional features, modification and variation of the disclosure embodied herein may be resorted to by those skilled in the art.

In the context of various embodiments, the articles "a", "an" and "the" as used with regard to a feature or element include a reference to one or more of the features or elements. As used herein, the term "and/or" includes any and all combinations of one or more of the associated listed items.

The reference signs included in parenthesis in the claims are for ease of understanding of the invention and have no limiting effect on the scope of the claims.

According to various embodiments, the term "electroactive material (EAM) membrane" may mean a membrane which may provide a mechanical response in response to an applied electrical field. The EAM membrane may include an EAM layer, such as an electroactive polymer (EAP), for example, an ionic EAP (iEAP) layer. Within the context of the present disclosure and in accordance with various embodiments, the EAM layer may include an iEAP, which may provide a mechanical response in response to an applied electrical driving signal.

According to various embodiments, the term "mechanical response" when describing an element comprising an EAM layer such as a segment, may mean for example, a displacing force which may include a bending, a change in at least one dimension such as length, a change in volume, a change in conformation, or a combination thereof. For example, a mechanical response of a segment of the plurality of segments may mean that the segment displaces or bends, for example, to one side.

According to various embodiments, the term "air pump" may mean a pump for compressing air to generate a pressure difference between two sides of the pump for example, to generate a net positive pressure at one side of the pump. For example, the air pump may include at least one micro-blower and may be configured to drive a flow of air and therefore control a pressure of a gas which is applied to another apparatus. As a further example, the air pump may provide a static pressure of a gas to the EAM membrane. Within the context of the present disclosure and in accordance with various embodiments, an air pump, may be configured to control the pressure of the gas applied to a side of the EAM membrane facing the substrate.

According to various embodiments, the term "pressure of a gas" may mean a force applied perpendicular to the surface of an object per unit area over which that force is distributed. For example, the pressure of the gas may be exerted by a flow of air applied to any surface in contact with it. Within the context of the present disclosure and in accordance with various embodiments, the application of the pressure of the gas may include applying a flow of air to a side of the EAM membrane facing the substrate. Since the membrane is at least partially moveable and/or at least partially elastically deformable, it may extend and/or move according to a displacing force which is the net force resulting from the difference in pressure on both sides of the membrane.

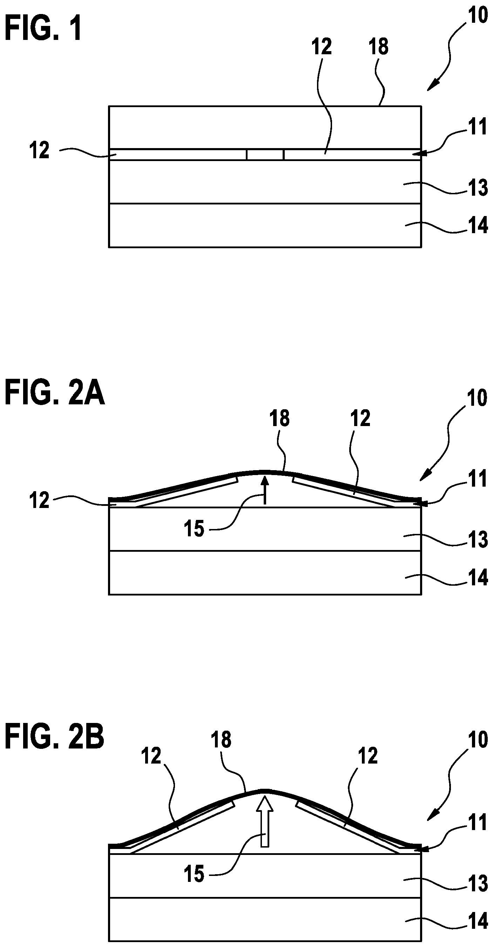

FIG. 1 provides a schematic illustration of a haptic feedback transducer 10 according to various embodiments. The haptic feedback transducer 10 includes a substrate 13. The haptic feedback transducer 10 includes an EAM membrane 11 disposed on the substrate 13. The EAM membrane 11 includes an EAM layer 12 configured to provide a mechanical response in response to an electrical driving signal. For example, the EAM membrane 11 includes segments of the EAM layer 12 disposed on the substrate 13. The haptic feedback transducer 10 also includes an air pump 14. The substrate 13 may be arranged between the EAM membrane 11 and the air pump 14, such that the air pump 14 is configured to control a pressure of a gas 15 applied to a side of the EAM membrane 11 which is facing the substrate 13.

According to various embodiments, the haptic feedback transducer 10 may further include an elastic cover layer 18, which may be disposed on the EAM membrane 11. The elastic cover layer 18 may be provided as a separate layer. For example, the elastic cover layer 18 may be disconnected from the EAM membrane 11. The elastic cover layer 18 may encapsulate and seal the haptic feedback transducer 10. For example, the elastic cover layer 18 may seal the pressure of the gas 15 applied to the EAM membrane 11.

According to various embodiments, the elastic cover layer 18 may include an elastic material. The elastic cover layer 18 may include or consist of a thin elastic layer, for example a double-sided acrylic foam tape or an acrylate elastomer. An example of a double-sided acrylic foam tape may be a 3M^{™} VHB^{™} (Very High Bond) film. An example of an acrylate elastomer may be a 3M^{™} VHB^{™} acrylic elastomer. As a further example, the elastic cover layer 18 may include or comprise a silicon rubber film such as a polydimethylsiloxane (PDMS) film, or a cross-linked silicon rubber such as ELASTOSIL^{®} film. In accordance with the various embodiments, the elastic cover layer 18 may exhibit an elastic modulus ranging between 0.1 MPa to 10 MPa.

According to various embodiments, the EAM membrane 11 may further include other components. For example, the EAM membrane 11 may include components such as electrode(s) disposed on the EAM membrane 11.

According to various embodiments, the EAM layer 12 may include an electroactive polymer (EAP), for example, an iEAP which may be used to generate large bending deformation under low driving voltage (such as 5 V or lower). EAP based actuators have been employed as haptic actuators for hand-held touch sensitive interfaces. Examples of EAPs may include: ferroelectric electroactive polymers, conducting polymers, and iEAP. There are still some limitations in using ferroelectric electroactive polymers or conducting polymers in these actuators as such actuators are more useful for vibration tactile feedback and not for static morphing applications, the latter which is required for hand-held touch sensitive interfaces. iEAPs are a subclass of EAPs and may be used to generate large bending deformations under low driving voltage, and are therefore a good soft actuator technology particularly for next-generation surface coverage haptic actuator applications. Advantages of iEAP include low voltage driving mechanisms, large bendable actuation deformation and out-of-plane (protrusion type) deformation. However, there are still several performance problems in using iEAP for conventional actuators such as small displacement, slow response time, low material properties, poor durability, high power consumption, and low holding and actuation force due to high back-relaxation issues, resulting in the lack of a perceivable haptic feedback force. For example, some iEAP actuators for generating large holding forces require a continuous power supply thereby leading to high power consumption. As such, the use of iEAP in conventional actuators have not been fully realized for surface coverage haptic applications which require large protrusive morphing motion and surface frequency modulation, for example, a shape-holding touch button interface with multi-level surface frequency modulation.

The haptic feedback transducer 10 as depicted in FIG. 1 is provided for illustration purposes and the disclosure is not limited thereto. The haptic feedback transducer may also include a channel between the substrate and the EAM membrane. Alternatively or in addition, the haptic transducer may include a channel integrated within the substrate and may be placed between the substrate and the EAM membrane. The channel may provide a passage for air to flow along. For example, the channel may direct the pressure of the gas from the air pump to the EAM membrane. The haptic feedback transducer may also include a housing module to seal the individual components of the haptic feedback transducer.

**FIGS. 2A and 2B** show a schematic illustration of the working mechanism of the haptic feedback transducer 10. The haptic feedback transducer 10 includes a first configuration (as shown in FIG. 2A), a second configuration (as shown in FIG. 2B), and optionally further configurations. For example in the first configuration, as shown in FIG. 2A, the haptic feedback transducer 10 includes a first displacing force in response to an electrical driving signal provided to the EAM membrane 11, even when the air pump 14 is switched off. For example, a level and/or shape is modified by the actuation of the EAM membrane 12 when an electrical driving signal of a first voltage is applied. In another example, a mechanical periodical protrusive morphing motion may be generated, wherein optionally, the periodical protrusive morphing motion may be controlled, for example with an electrical driving signal comprising a first frequency. The electrical driving signal is further modulated. The haptic feedback transducer 10 has a configuration wherein the displacing force generated by the haptic feedback transducer 10 is in response to the pressure of the gas 15 applied by the air pump 14. For example, an electrical driving signal is not provided to the EAM membrane 11, such that the haptic feedback transducer 10 only receives the static pressure of the gas from the air pump 14. A steady-state holding force may therefore be generated by the haptic feedback transducer 10. Further, the elastic cover layer 18 may be elastically deformable upon the application of the pressure of the gas 15 to the EAM membrane 11. For example, the elastic cover layer 18 may seal the pressure of the gas 15 applied to the EAM membrane 11.

**FIG. 2B** provides a schematic illustration of a second displacing force generated in the second configuration. As shown in FIG. 2B, the second displacing force is generated in response to an electrical driving signal applied to the EAM membrane 11, and when the air pump 14 is switched on to provide the pressure of the gas 15 to the EAM membrane 11. For example, an electrical driving signal applied to the EAM membrane 11 is synchronized with the pressure of the gas 15 provided by the air pump 14. As a result, the haptic feedback transducer 10 generates the second displacing force, which is larger than the first displacing force. For example, the second displacing force may be a larger actuation and holding force in comparison to the first displacing force. As a further example, the second displacing force may be larger than the displacing force generated when only the air pump 14 is in operation. In other words, due to the actuation of the EAM membrane 11 and the air pump 14, the second displacing force generated by the haptic feedback transducer 10 is an improved displacing force with large morphing deformations. The second displacing force may be substantially equal to the addition of the displacing force generated when only the air pump 14 is in operation with the first displacing force generated when the electrical driving signal is applied only to the EAM membrane 11. For example, the second displacing force may be beneficial as it may provide an enhanced haptic perception to the user operating the haptic feedback transducer. As a further example, the second displacing force may be a realistic and perceivable haptic feedback force provided to the user.

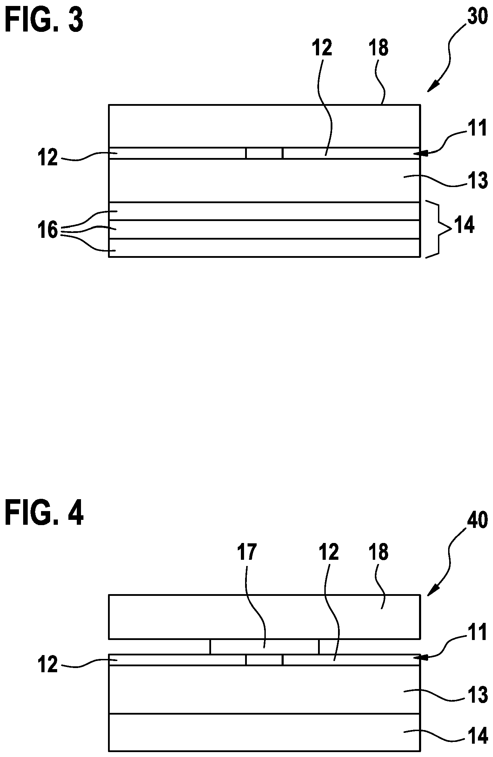

**FIG. 3** shows a schematic illustration of a haptic feedback transducer 30 according to various embodiments. The haptic feedback transducer 30 may include an air pump 14, which further includes at least one micro-blower 16. For example, the air pump 14 may include a plurality of micro-blowers 16, such as a stack of micro-blowers 16. As a further example, the air pump 14 may include a stack of three micro-blowers 16 which are stacked in a series connection (on top of one another). The micro-blowers 16 within the air pump 14 may provide the pressure of the gas 15, for example, the static pressure of the gas 15 to the EAM membrane 11. Depending on the user's preference, the following properties of the air pump 14 may be adjusted by configuring design parameters: number of micro-blowers, and the type of series connection of the micro-blowers. The design parameters of the micro-blower(s) 16 within the air pump 14 may also be adjusted, for example one or more of a maximum voltage, a maximum flow rate, a maximum pressure, a size, may be selected as required for an application. As such, the resultant displacing and holding force may therefore be easily adjusted. For example, a larger displacing force may be generated by increasing the number of micro-blowers 16 in the air pump 14. As a further example, a larger displacing force may be generated by increasing the maximum voltage, flow rate, and/or pressure provided to the micro-blower(s) 16.

According to various embodiments, the micro-blower(s) may include a piezoelectric motor, which is based on the change in shape of a piezoelectric material when an electric field is applied. For example, the micro-blower(s) may be designed to operate as a blower by applying the ultrasonic vibrations of the piezoelectric material as the drive source. As a further example, the micro-blower(s) may include a piezoelectric micro-blower. Piezoelectric micro-blowers may be thin, compact, lightweight and silent and may provide a high air flow rate. Further, piezoelectric micro-blowers may be easily mounted to the haptic feedback transducer, for example, onto the substrate.

**FIG. 4** shows a schematic illustration of a haptic feedback transducer 40 according to various embodiments. The haptic feedback transducer 40 may further include a centerpiece 17 superposed on the EAM membrane 11, which includes the EAM layer 12. For example, the centerpiece 17 may partially cover a portion of the EAM layer 12, and may partially cover a portion of the EAM membrane 11. The centerpiece 17 may be configured to be deformable upon actuation of the EAM membrane 11, and/or application of the pressure of the gas 15 (e.g. static pressure of the gas) provided by the air pump 14.

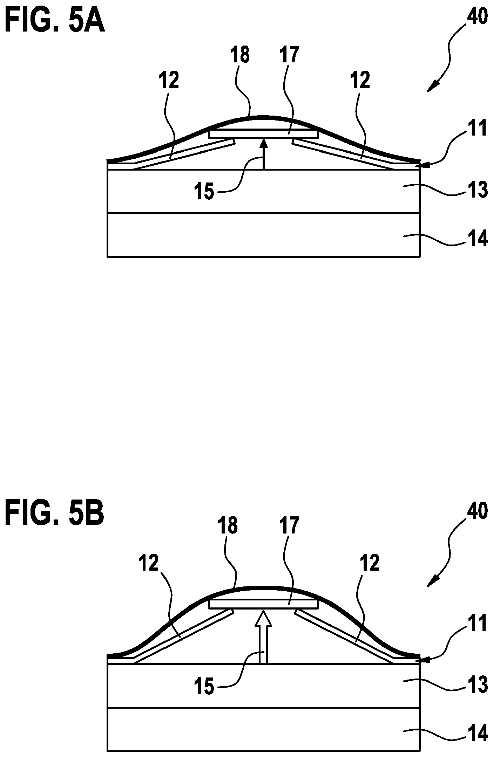

**FIGS. 5A and 5B** show a schematic illustration of the working mechanism of the haptic feedback transducer 40 according to various embodiments. The haptic feedback transducer 40 may include a first configuration (as shown in FIG. 5A), a second configuration (as shown in FIG. 5B), and optionally further configurations. For example in the first configuration, as shown in FIG. 5A, the centerpiece 17 has a first height, such that the centerpiece 17 is in a first position relative to the EAM layer 12. According to various embodiments and within the context of the disclosure, the term "height" may mean the height difference between a portion closer (proximal) to the substrate and a portion further (distal) from the substrate. For example, an electrical driving signal may be applied to the EAM membrane 11 and the air pump 14 may not be in operation in the first configuration. Therefore, the centerpiece 17 may be in the first position only due to the actuation of the EAM membrane 11. In the second configuration, as shown in FIG. 5B, the centerpiece 17 may protrude above the EAM layer 12 such that the centerpiece has a second height and may be in a second position relative to the EAM layer 12. The second height at the second position may be greater than the first height of the centerpiece 17 in the first position. For example, the second configuration may be one which results in the large protrusive morphing motion of the EAM layer 12 and the centerpiece 17, which may be in response to the actuation of the EAM membrane 11, and the operation of the air pump 14. As a further example, the centerpiece 17 may play a relevant role in allowing the morphing motion to create a sharp edge deformation.

According to various embodiments, the centerpiece may include a lightweight stiff material. The centerpiece may include a lightweight pre-shaped layer with inelastic properties. For example, the centerpiece may include or comprise a plastic layer with a thickness ranging from 0.5 mm to 1.0 mm, an elastic modulus of above 2 GPa and a density of less than 1.5 g/cm³. As a further example, the centerpiece may include materials such as polymethyl methacrylate, polycarbonates, polyethylene terephthalate and acrylic plates. The centerpiece may be at least partially superposed on the EAM membrane. The centerpiece may act as a passive layer for perpendicular movement and may therefore enable mechanical morphing deformation with sharp edges. For example, the sharp edge deformation may include the second configuration where the centerpiece 17 protrudes above the EAM layer 12 such that the centerpiece is at the second height and at the second position relative to the EAM layer 12. The second height may be greater than the first height. The sharp edges can be conceptually proved via the perpendicular movement of the centerpiece due to morphing motion of the underneath actuating segments of the EAM layer. Such sharp edge deformation is beneficial as it further enhances the haptic perception to the user operating the haptic feedback transducer.

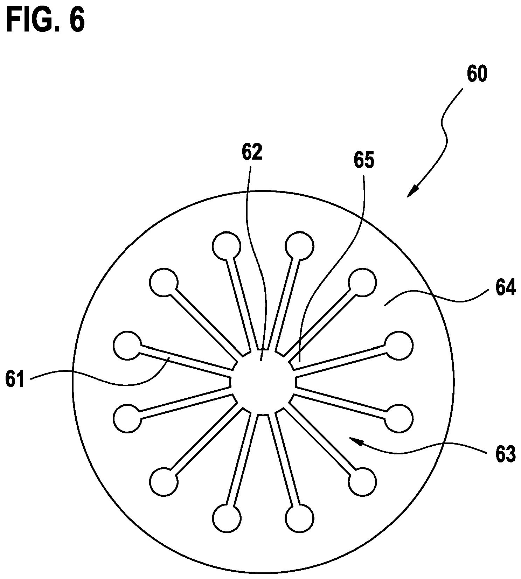

**FIG. 6** shows a schematic illustration of a top-view of the EAM layer 12 according to various embodiments. For illustration purposes the top-view may be identical to a top-view of the EAM layer 12 of the haptic feedback transducer 10 of FIG. 1. The EAM layer 12 may include a center 62 from which a plurality of radial cuts 61 may radially extend. The portion between two adjacent cuts may define a plurality of segments 63. For example, a segment 63 may be petal-shaped and may include the EAM layer 12. In FIG. 6, only one of the plurality of cuts and of the plurality of segments are indicated with reference numerals, however it is to be understood that the term "plurality" within the meaning of various embodiments, may mean 2 or more, for example all cuts and/or all of the segments. According to various embodiments, the segment 63 of the plurality of segments may also include a first portion 64, for example an end which is distal (outer) to the center 62, and a second portion 65, for example an end which is proximal (inner) to the center 62. Within the context of the present disclosure, the segment 63 of the EAM layer 12 may be referred to as an EAM cantilever beam.

According to various embodiments, the term "cut" may mean an interruption on the EAM layer. For example, interruptions or breaks may be provided within the EAM layer such that a portion between two adjacent interruptions may define a segment. Within the context of the present disclosure and in accordance with the various embodiments, the term "cut" refers to an opening EAM layer, and is not limited to an opening provided by way of cutting the EAM layer.

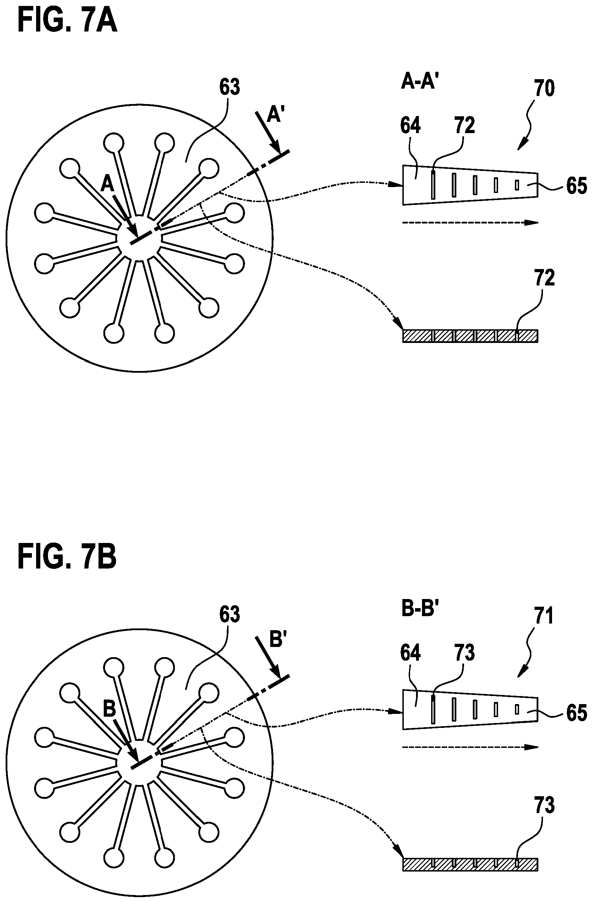

**FIG. 7A** shows a schematic illustration of the EAM layer 12 according to various embodiments. The left-hand view is a top-view of the EAM layer 12. The upper right-hand view 70 is a top-view of a segment 63, and the lower right-hand view 70 is a cross-sectional view through section A-A' of the segment 63. Referring to the upper and lower right-hand views 70, the segment 63 may include a plurality of slits 72. For example, the plurality of slits 72 may be arranged and extend from the first portion 64 of the segment 63 to the second portion 65 of the segment 63. As a further example, the slits 72 may form a through opening, which is through a thickness direction of the EAM layer 12. The through opening may be elongated. In some embodiments, the through opening may be limited to within a segment 63.

According to various embodiments, the term "thickness" may mean a distance between two opposite sides of the EAM layer. In the context of the present disclosure and in accordance with various embodiments, the thickness of the EAM layer may include the distance from the top and the bottom surfaces of the EAM layer.

**FIG. 7B** shows a schematic illustration of an EAM layer 12 according to various embodiments. The left-hand view is a top-view of the EAM layer 12. The upper right-hand view 71 is a top-view of a segment 63, and the lower right-hand view 71 is a cross-sectional view through section B-B' of the segment 63. Referring to the upper and lower right-hand views 71, the segment 63 may include a plurality of recesses 73. For example, the plurality of recesses 73 may be arranged and extend from the first portion 64 of the segment 63 to the second portion 65 of the segment 63. For example, the recesses 73 may form a hollow or depression through a thickness of the EAM layer 12, and may not cut or open through the entire thickness of the EAM layer 12. As a further example, the recesses 73 may partially cut through the thickness of the EAM layer 12.

According to various embodiments, the orientation, dimensions (width, length), number and location of the plurality of slits and/or of the plurality of recesses may affect the actuation performance of the improved haptic feedback transducer. For example, the slits and/or the recesses may be in an arced configuration or a radial configuration. For example, in the arced configuration, the slits and/or recesses may form a circular arc having a common circular center, wherein the common circular center may be at the center of the EAM layer. Alternatively, in a radial configuration, the slits and/or recesses may be a radial segment of radii originating at the center of the actuator.

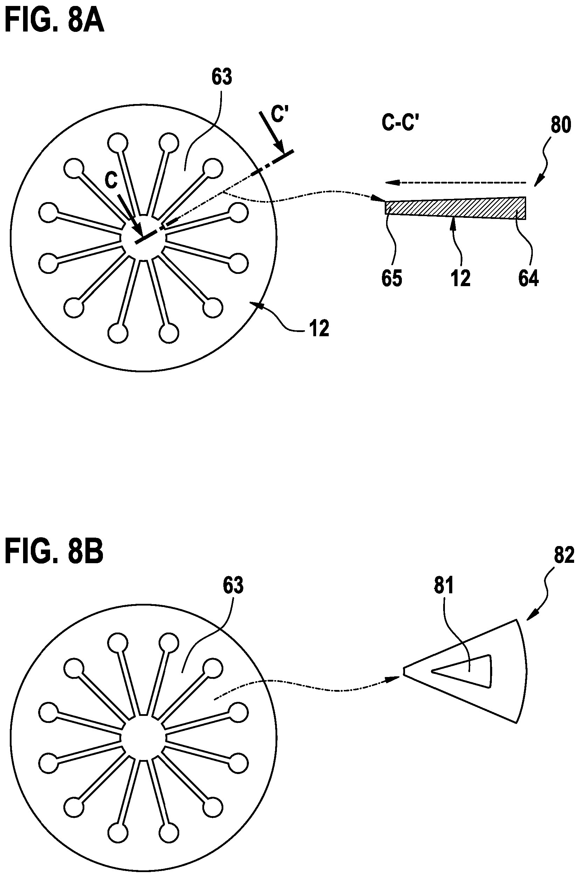

**FIG. 8A** shows a schematic illustration of an EAM layer 12 according to various embodiments. The left-hand view is a top-view of the EAM layer, and the right-hand view 80 is a cross-sectional view through section C-C' of the segment 63. The thickness of the segment 63 may decrease from the first portion 64 to the second portion 65. For example, the EAM layer 12 at the first (outer) portion 64 may be thicker than the EAM layer 12 at the second (inner) portion 65. Within the context of the present disclosure, the segment 63 according to FIG. 8A may be referred to as having a slender beam configuration.

According to various embodiments, a segment including the plurality of slits, recesses, and/or the decreasing thickness of the EAM layer may help reduce bending stiffness of an EAM cantilever beam structure, resulting in a larger displacing force and faster actuation response of the improved haptic feedback transducer.

**FIG. 8B** shows a schematic illustration of an EAM layer 12 according to various embodiments. The left-hand view is a top-view of the EAM layer 12, and the right-hand view 82 is a top-view of the segment 63. The segment 63 may include an open window 81. For example, an opening or space may be provided through the thickness of the segment 63. The open window 81 may provide a partial opening on the segment 63. For example, the open window 81 may occupy a partial area of the total surface area of the segment 63.

According to various embodiments, the open window allows the formation of a protruded portion within the segment, and allows for the generation of better modulated surface motion (surface frequency modulation). For example, the haptic feedback transducer including open windows on the EAM layer may provide a larger and more perceivable displacement, and may therefore enhance the haptic perception to the user operating the haptic feedback transducer.

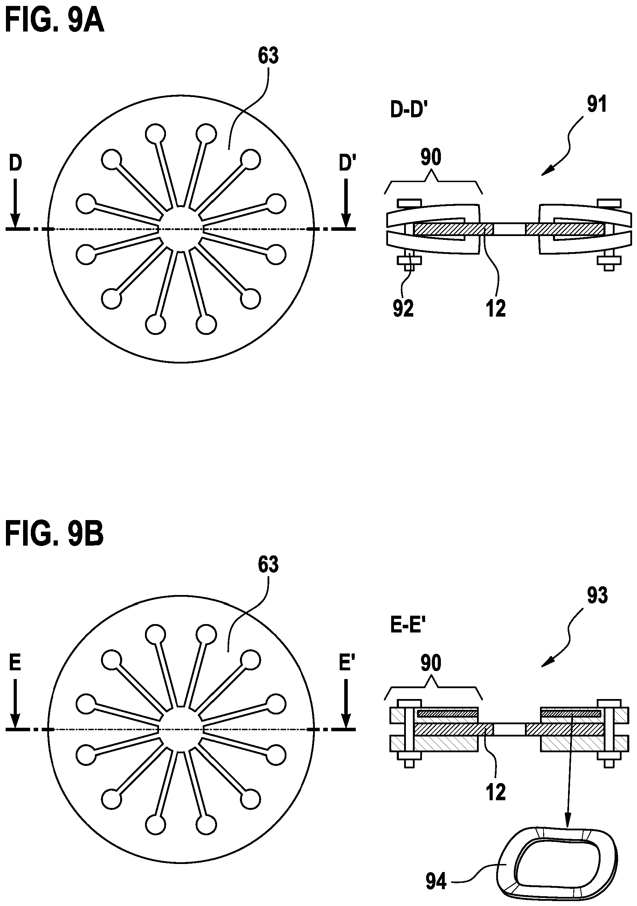

**FIGS. 9A and 9B** show schematic illustrations of EAM layers 12 which may be mechanically attached to substrates 13 by fasteners 90. For illustration purposes, the left-hand views are the top-views of the EAM layer 12. The right-hand views 91 and 93 are the cross-sectional views through section D-D' and E-E' the first (outer) 64 portion of the segment 63. The segment of the EAM layer 12 may be mechanically attached to the underlying substrate 13 (not shown) by a fastener 90.

According to various embodiments, a fastener may include a device that mechanically joins and/or affixes two or more objects. A fastening mechanism may be permanent, and the fastener may be used to create non-removable joints. For example, the fastener may include a device used to mechanically join or affix the EAM layer to the substrate. As a further example, the fastener may include concave or convex shaped clamping parts. For example, as compared to EAM cantilever beams without the fastener, the concave or convex EAM cantilever beams may be provided by utilizing concave or convex shaped clamping parts to generate a larger, more stable and repeatable displacing motion as a result of the bi-stable locomotion of the buckled EAM cantilever structure.

With reference to FIG. 9A, a fastener may include a pre-shaped clamping device, for example, a simple support. A simple support may include a pin or a roller support 92, which may include fasteners such as screws and/or rivets to mechanically clamp the EAM layer 12 to the substrate 13. Alternatively and with reference to FIG. 9B, a fastener may include a partial clamp. For example, the partial clamp may include a wave spring 94 which may be embedded within the clamp. For example, the wave spring 94 may be superior to traditional coil springs as they provide a lower work height with the same force, thereby providing smaller assemblies that use less materials and results in lower production costs. Further, the use of the wave spring 94 may provide a stronger displacing force and enhances the haptic perception provided to the user. For example, the wave spring 94 may reduce the contact region of the clamped area. As a result, the EAM cantilever beam including a wave spring 94 may produce an improved morphing motion with greater degrees of freedom of the morphing motion even under a low driving voltage.

According to various embodiments, the term "plurality of haptic feedback transducer" may denote two or more haptic feedback transducers. For example, the haptic feedback interface may include three, four or five or more haptic feedback transducers. Within the context of the present disclosure and in accordance with the various embodiments, the term "plurality" defines two or more haptic feedback transducers.

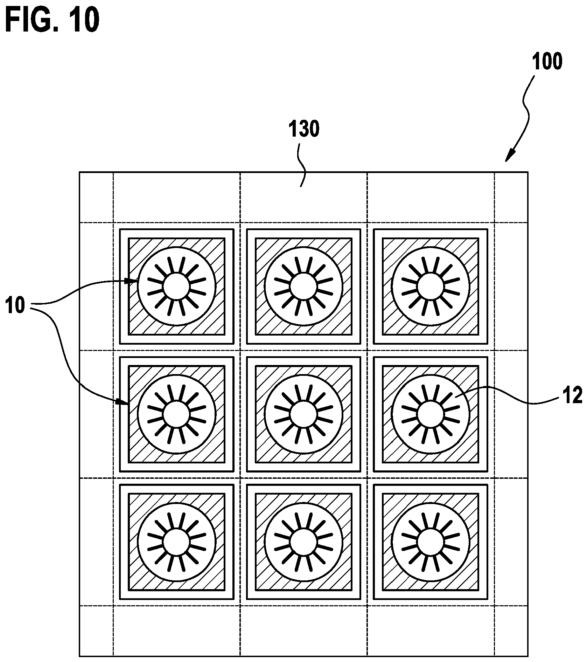

**FIG. 10** shows a schematic illustration of a haptic feedback interface 100 according to various embodiments. A haptic feedback interface 100 may include one or a plurality of haptic feedback transducer 10. For example, the haptic feedback interface 100 may include one haptic feedback transducer 10, or two or more haptic feedback transducers 10. The plurality of haptic feedback transducers 10 may be arranged according to a pre-defined pattern, for example a matrix structure. The plurality of haptic feedback transducers 10 may be provided on a common substrate 130. For example, the plurality of haptic feedback transducers 10 may share a common substrate 130. The haptic feedback interface 100 may be a touch sensitive interface, for example, a keyboard, a keypad, part of a touch screen, or part of a display. The haptic feedback interface 100 may include a multi-level button array, and each button of the array includes a haptic feedback transducer in accordance with the various embodiments of the present disclosure. The one or more feedback transducers 10 may be positioned, for example, over or under a display layer.

According to various embodiments, the haptic feedback interface including one or the plurality of haptic feedback transducers may be electrically coupleable to an electrical driving circuit, such that that an electrical driving signal may be applied independently to each of the haptic feedback transducers or wholly to the plurality of the haptic feedback transducers, by the electrical driving circuit. For example, the electrical driving circuit may provide an EAM electrical driving signal to the EAM layer. As a further example, the electrical driving circuit may provide an air pump electrical driving signal to the air pump, for example, the micro-blower(s) within the air pump.

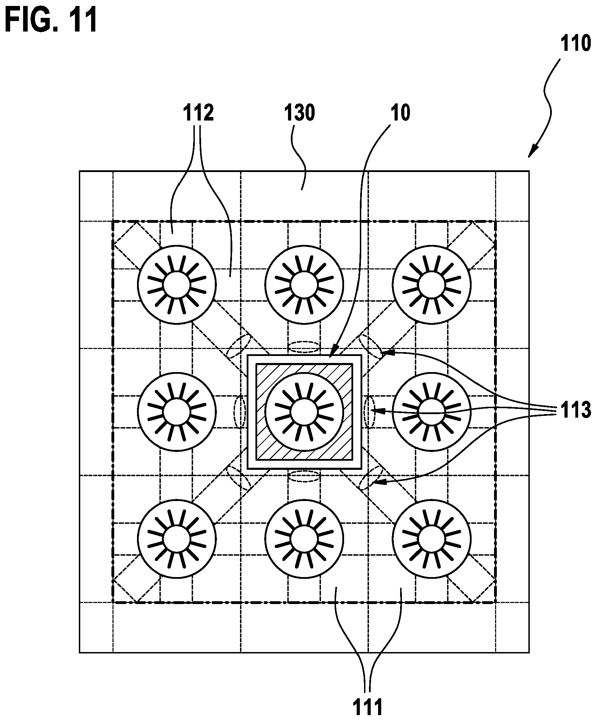

**FIG. 11** shows a schematic illustration of a haptic feedback interface 110 according to various embodiments. A haptic feedback interface 110 may include one or more haptic feedback transducers 10 in accordance with the various embodiments of the present disclosure. In addition, the haptic feedback interface 110 may include one or more haptic feedback transducers which are air pump free 111. For example, the haptic feedback transducers which are air pump free 111 may not include an individual air pump within the haptic feedback transducer (compare to FIG. 1 which provides an illustration of a haptic feedback transducer which has an air pump 14). The haptic feedback transducers which are air pump free 111 may include the EAM membrane disposed on a common substrate 130. The haptic feedback interface 110 may further include one or more air channels 112. The air channels 112 may provide a connection between at least one haptic feedback transducer 10 and at least one haptic feedback transducer which are air pump free 111. For example, the air channels 112 may provide a channel for the transmission of the pressure of the gas from the air pump of the at least one haptic feedback transducer 10, to at least one of the haptic feedback transducers which are air pump free 111.

The air channel 112 may further include a valve 113 or a plurality of valves 113 in accordance with various embodiments. For example, the valve 113 may include a device that directs or controls the air flow through the air channel 112 by opening, closing or partially obstructing the air channel 112. For example, the valve 113 may be in an open configuration to allow the pressure of the gas to flow from the air pump of the at least one haptic feedback transducer 10, to at least one of the haptic feedback transducers which are air pump free 111. Alternatively or in addition, the valve 113 may be in a closed or partially obstructed configuration to reduce or block the pressure of the gas from the air pump of the at least one haptic feedback transducer 10, to at least one of the haptic feedback transducers which are air pump free 111. The valves 113 may be configured to control the pressure of the gas provided to one or more of (for example each of) the haptic feedback transducers which are air pump free 111. As a result, the number of air pump(s) required in the haptic feedback interface 110 may be reduced, leading to a lower power consumption.

According to various embodiments, the haptic feedback transducer may be a multi-level haptic feedback transducer. The haptic feedback interface comprising one or more haptic feedback transducers may be a multi-level haptic feedback interface.

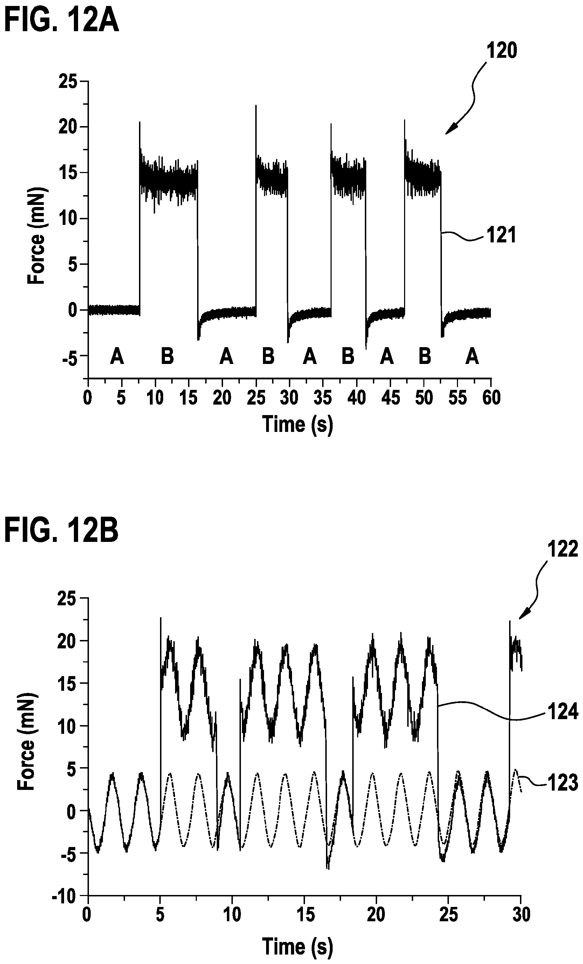

**FIG. 12A** shows a plot 120 showing a force vs. time signal 121 generated by the haptic feedback transducer 10 without actuation of the EAM membrane, in accordance with various embodiments. For example, plot 120 may show the displacing force generated by the haptic feedback transducer 10 when the air pump is in operation. The air pump being in operation may mean that the air pump is being controlled by the air pump electrical driving signal provided to the air pump. Signal 121 may include a first state A (denoted by time frame "A") and a second state B (denoted by time frame "B"). The first state A may be a state when the air pump may be turned off, and consequently no force may be generated by the haptic feedback transducer. The second state B may be a state where the air pump may be turned on to provide the pressure of the gas to the EAM membrane. For example, the air pump may control the static pressure of the gas applied to a side of the EAM membrane facing the substrate. As illustrated in FIG. 12A, a steady-state holding force of 1.5 × 10⁻² N may be generated solely from the operation of the air pump. In other words, a steady-state force of 1.5 × 10⁻² N may be produced by the haptic feedback transducer 10 when the air pump is in operation, and when no electrical driving signal is applied to the EAM membrane.

**FIG. 12B** shows a plot 122 showing a force vs. time signal generated by the actuation of the EAM membrane 123 (indicated by a dotted line), and the force vs. time signal generated by actuation of the EAM membrane and the operation of the air pump 124 (indicated by a solid line). Signal 123 illustrates that the displacing force generated by the haptic feedback transducer 10 (only by the EAM membrane 12) may be periodic with a maximum displacing force of 0.5 × 10⁻² N. Signal 124 illustrates that the displacing force generated by the haptic feedback transducer 10 (actuation of the EAM membrane 12 in combination with the air pump 14) may be enhanced by four times to a maximum of 2.0 × 10⁻² N. The displacing force generated (as shown in signal 124) may include two feedback levels, namely a static protrusive morphing force of 1.5 × 10⁻² N generated by the pressure of the gas applied to a side of the EAM membrane (signal 121 in FIG. 12A), and a modulated force of 1.0 × 10⁻² N peak-to-peak (signal 123 in FIG. 12B), resulting in the realization of two feedback levels as shown in signal 124. The haptic feedback transducer 10 may function as a multi-level haptic feedback transducer since the user may adjust the displacing force generated by the haptic feedback transducer 10 by modulating the EAM electrical driving signal and/or tailoring the driving parameters (for example, by adjusting the driving frequency, voltage and waveform) of the air pump electrical driving signal. For example, the user may increase an initial displacing force generated by the haptic feedback transducer 10 by increasing the driving voltage of the air pump electrical driving signal and/or increasing the driving voltage of the EAM electrical driving signal, such that a resultant displacing force generated by the haptic feedback transducer 10 may be increased.

According to various embodiments, a displacing force generated by the haptic feedback transducer 10 may be due to the actuation of the one or more segments of the EAM membrane. For example, the displacing force may be in response to the electrical driving signal applied to the EAM membrane. By controlling the driving parameters of the electrical driving signal applied to the EAM membrane, the haptic feedback transducer 10 may generate various displacing forces. For example, the electrical driving signal applied to the EAM membrane may be modulated based on a driving voltage, waveform or frequency of the EAM electrical driving signal. Alternatively and in addition, a displacing force generated by the haptic feedback transducer 10 may also be due to operation of one or more micro-blowers of the air pump, which provide the pressure of the gas which is applied to a side of the EAM membrane. By controlling the driving parameters of the one or more micro-blowers, the haptic feedback transducer 10 may generate various displacing forces. For example, the haptic feedback transducer 10 may produce various deformation levels. The levels of deformation produced by the haptic feedback transducer 10 may be controllable since the user may modulate the electrical driving signal applied to the EAM membrane, and/or tailor the driving parameters of the micro-blowers.

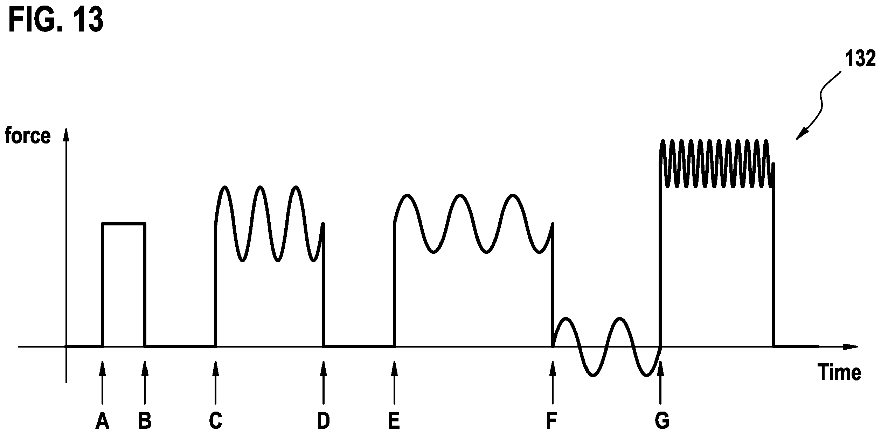

**FIG. 13** shows a plot 132 illustrating various multi-level feedback forces that may be generated by the haptic feedback transducer. For example, various displacing forces are generated by adjusting the driving parameters of the air pump electrical driving signal applied to the air pump, and by modulating the electrical driving signal applied to the EAM membrane. For illustration purposes, plot 132 may be a force vs. time signal sampled at different time points. Time point "A" may denote a first event, for example, when the micro-blower(s) may be turned on, and no EAM electrical driving signal is applied to the EAM membrane. A steady-state holding force may be generated by the haptic feedback transducer 10 due solely to the operation of the micro-blower(s). Time point "B" may denote a second event, for example, when the micro-blower(s) may be turned off and no EAM electrical driving signal is applied to the EAM membrane. As a result, no displacing force may be generated by the haptic feedback transducer 10. Time-point "C" may denote a third event, for example, when the electrical driving circuit is configured to provide a first air pump electrical driving signal to the air pump and provides a first EAM electrical driving signal to the EAM membrane. A first displacing force that is periodic in nature and of a first frequency and amplitude level may be generated. Time-point "D" may denote a fourth event (similar to time-point "B", the second event), when the micro-blower(s) are turned off, and no EAM electrical driving signal is provided to the EAM membrane, so that no force may be generated by the haptic feedback transducer 10. Time-point "E" may denote a fifth event, for example, when the user provides the first air pump electrical driving signal to the air pump. The first air pump electrical driving signal may be the same as that applied during time-point "C'. A second EAM electrical driving signal may be applied to the EAM membrane. A second displacing force which is periodic in nature and of a second frequency and amplitude level may be generated. The second displacing force may be lower than the first displacing force. For example, the second frequency and amplitude levels may be lower than the first frequency and amplitude levels (during time-point "C"). For example, the user may modulate the EAM electrical driving signal applied to the EAM membrane. Time-point "F" may denote a sixth event, for example, when the user turns the micro-blower off but continues to provide an EAM electrical driving signal to the EAM membrane. The displacing force generated by the haptic feedback transducer 10 may be markedly reduced when the micro-blower(s) are not in operation. Time-point "G" may denote a seventh event, for example, when the user provides a second air pump electrical driving signal to the air pump and provides a third EAM electrical driving signal to the EAM membrane. A third displacing force that is periodic in nature and of a third frequency and amplitude level may be generated. It may be seen that the third displacing force may be higher than the first and second displacing forces. For example, the third frequency may be higher than the first and second frequencies of the first and second displacing forces, but the third amplitude level may be lower than that of the first and second amplitude levels of the first and second displacing forces. As a result, the third displacing force may be higher than the first and second displacing forces (during time-points "C" and "E", respectively). For example, the user may adjust the driving parameters (for example, waveform, voltage and frequency levels) of the air pump electrical driving signal, and/or modulate the EAM electrical driving signal applied to the EAM membrane. As a result, displacing forces with varying amplitude and frequency levels may be generated by the haptic feedback transducer 10 by tailoring the driving parameters of the air pump electrical driving signal and/or, by modulating the EAM electrical driving signal applied to the EAM membrane.

In accordance with various embodiments, a multi-level haptic feedback transducer may thus be provided. Further, a multi-level haptic feedback interface comprising one or more haptic feedback transducers may be also be provided.

Advantageously, the haptic feedback transducer including the air pump may provide a controllable pressure of a gas to the EAM membrane, since the driving parameters (for example, driving voltage, amplitude and frequency) supplied to the air pump may be modulated by the user. Alternatively or in addition, the electrical driving signal applied to the EAM membrane may be modulated by the user. As a result, the displacing forces and deformation level of the haptic feedback transducer may be controllable. Further, the haptic feedback transducer in accordance with the various embodiments of the present disclosure may require lower power consumption, as the EAM membrane does not need to be continually excited due to the incorporation of the air pump. For example, the air pump may provide a steady-state holding force and hence, the EAM membrane does not need to be continually excited to generate a haptic feedback force which is perceivable by the user.

The multi-level haptic feedback transducer, and the multi-level haptic feedback interface in accordance with the various embodiments may provide a multi-level shape-changing and/or -holding touch interface. The interface may generate large protrusive forces and may include surface frequency modulated haptic feedback effects. As a result, a user may experience significant enhancement in the perceivable feedback and holding force, and an improvement in back-relaxation issues. In addition, the haptic feedback transducer may provide fast response time with low power consumption.

## Claims

1. A haptic feedback transducer (10) comprising:
an electroactive material (EAM) membrane (11) disposed on a substrate (13), wherein the EAM membrane comprises an EAM layer (12) configured to provide a mechanical response in response to an electrical driving signal; and
an air pump (14) configured to control a pressure of a gas (15) applied to a side of the EAM membrane facing the substrate,
**characterised in that**:
the haptic feedback transducer (10) provides multi-level haptic feedback by modulating the electrical driving signal provided to the EAM membrane (11) in combination with the control of the pressure of the gas (15) provided by the air pump (14).

2. The haptic feedback transducer (10) of claim 1, further comprising an elastic cover layer (18) disposed on the EAM membrane (11).

3. The haptic feedback transducer (30) of claim 1 or claim 2, wherein the air pump (14) comprises a stack of micro-blowers (16).

4. The haptic feedback transducer (40) of any one of claims 1 to 3, wherein the EAM membrane comprises a centerpiece (17) superposed on the EAM layer (12),
wherein the centerpiece (17) is configured to be deformable upon application of the pressure of the gas (15) applied to the EAM membrane (11).

5. The haptic feedback transducer (10) of any one of claims 1 to 4,
wherein the EAM layer (12) comprises one or more slits (72) providing an opening through a thickness direction of the EAM layer (12), and/or
wherein the EAM layer (12) comprises one or more open windows (81) providing an opening through a thickness direction of the EAM layer (12).

6. The haptic feedback transducer (10) of any one of claims 1 to 5,
wherein the EAM layer (12) comprises one or more recesses (73) through a thickness direction of the EAM layer (12).

7. The haptic feedback transducer (10) of any one of claims 1 to 6,
wherein a thickness of the EAM layer (12) decreases from an outer portion of the EAM layer (64) to an inner portion of the EAM layer (65).

8. The haptic feedback transducer (10) of claim 7, further comprising a fastener (90),
wherein the EAM layer (12) is mechanically attached to the substrate (13) by the fastener (90).

9. The haptic feedback transducer (10) of claim 8,
wherein the fastener (90) comprises at least one of a pin, a roller support (92), or a wave spring (94), and/or
wherein the fastener (90) comprises a concave- or convex- shaped clamping component.

10. The haptic feedback transducer (10) of any one of claims 1 to 9,
wherein the EAM layer (12) comprises a plurality of segments (91) radially extending from a center (62), and
optionally, wherein the segments (63) are radially separated from each other by a plurality of cuts.

11. A haptic feedback interface (100), comprising one haptic feedback transducer (10) according to any one of claims 1 to 10, or two or more haptic feedback transducers (10) according to any one of claims 1 to 10 sharing a common substrate (130).

12. The haptic feedback interface (110) of claim 11, further comprising additional haptic feedback transducers which are air pump free (111), and air channels (112) for air flow from at least one of the air pumps of the one or more haptic feedback transducers (10),
wherein the air channels (112) comprise respective valves (113) configured to control the air flow.

13. The haptic feedback interface of claim 11 or claim 12, further comprising an electrical driving circuit,
wherein the electrical driving circuit is configured to provide a first EAM electrical driving signal to the EAM layer,
wherein the electrical driving circuit is configured to provide a first air pump electrical driving signal to the air pump.

14. The haptic feedback interface of claim 13, wherein the electrical driving circuit is configured to provide:
a second EAM electrical driving signal having an amplitude different from the first EAM electrical driving signal, and/or
a second air pump electrical driving signal having an amplitude different from the first air pump electrical driving signal.

15. The haptic feedback interface of claim 13 or claim 14,
wherein the first or the second EAM electrical driving signal are modulatable based on a driving voltage, waveform or frequency of the EAM electrical driving signal, and/or
wherein the first or the second air pump electrical driving signal are modulatable based on a driving voltage, waveform or frequency of the air pump electrical driving signal.

## Patentansprüche

1. Wandler für haptische Rückmeldungen (10), umfassend:
eine Membran (11) aus elektroaktivem Material (EAM), die auf einem Substrat (13) angeordnet ist, wobei die EAM-Membran eine EAM-Schicht (12) umfasst, die so konfiguriert ist, dass sie in Reaktion auf ein elektrisches Ansteuersignal eine mechanische Reaktion liefert; und
eine Luftpumpe (14), die so konfiguriert ist, dass sie einen Druck eines Gases (15) steuert, das auf eine dem Substrat zugewandte Seite der EAM-Membran aufgebracht wird,
**dadurch gekennzeichnet, dass**:
der Wandler (10) für haptische Rückmeldungen durch Modulieren des elektrischen Ansteuersignals, das an die EAM-Membran (11) gegeben wird, in Kombination mit der Steuerung des Drucks des Gases (15), das von der Luftpumpe (14) geliefert wird, mehrstufige haptische Rückmeldungen bereitstellt.

2. Wandler (10) für haptische Rückmeldungen nach Anspruch 1, ferner umfassend eine elastische Deckschicht (18), die auf der EAM-Membran (11) angeordnet ist.

3. Wandler für haptische Rückmeldungen (30) nach Anspruch 1 oder Anspruch 2, wobei die Luftpumpe (14) einen Stapel von Mikrogebläsen (16) umfasst.

4. Wandler (40) für haptische Rückmeldungen nach einem der Ansprüche 1 bis 3, wobei die EAM-Membran ein Mittelstück (17) umfasst, das auf der EAM-Schicht (12) liegt,
wobei das Mittelstück (17) so konfiguriert ist, dass es bei Aufbringen des Drucks des auf die EAM-Membran (11) aufgebrachten Gases (15) verformbar ist.

5. Wandler (10) für haptische Rückmeldungen nach einem der Ansprüche 1 bis 4,
wobei die EAM-Schicht (12) einen oder mehrere Schlitze (72) umfasst, die eine Öffnung durch eine Dickenrichtung der EAM-Schicht (12) bereitstellen, und/oder
wobei die EAM-Schicht (12) ein oder mehrere offene Fenster (81) umfasst, die eine Öffnung durch eine Dickenrichtung der EAM-Schicht (12) bereitstellen.

6. Wandler (10) für haptische Rückmeldungen nach einem der Ansprüche 1 bis 5,
wobei die EAM-Schicht (12) eine oder mehrere Ausnehmungen (73) durch eine Dickenrichtung der EAM-Schicht (12) umfasst.

7. Wandler (10) für haptische Rückmeldungen nach einem der Ansprüche 1 bis 6,
wobei eine Dicke der EAM-Schicht (12) von einem äußeren Abschnitt der EAM-Schicht (64) zu einem inneren Abschnitt der EAM-Schicht (65) abnimmt.

8. Wandler (10) für haptische Rückmeldungen nach Anspruch 7, ferner umfassend ein Befestigungsmittel (90),
wobei die EAM-Schicht (12) durch das Befestigungsmittel (90) mechanisch an dem Substrat (13) angebracht ist.

9. Wandler (10) für haptische Rückmeldungen nach Anspruch 8,
wobei das Befestigungsmittel (90) einen Stift und/oder einen Rollenträger (92) und/oder eine Wellenfeder (94) umfasst und/oder
wobei das Befestigungsmittel (90) ein konkav oder konvex geformtes Klemmteil umfasst.

10. Wandler (10) für haptische Rückmeldungen nach einem der Ansprüche 1 bis 9,
wobei die EAM-Schicht (12) eine Vielzahl von Segmenten (91) umfasst, die sich radial von einem Zentrum (62) aus erstrecken, und
wobei die Segmente (63) wahlweise durch eine Vielzahl von Einschnitten radial voneinander getrennt sind.

11. Schnittstelle für haptische Rückmeldungen (100), die einen Wandler für haptische Rückmeldungen (10) nach einem der Ansprüche 1 bis 10 oder zwei oder mehr Wandler für haptische Rückmeldungen (10) nach einem der Ansprüche 1 bis 10 umfasst, die sich ein gemeinsames Substrat (130) teilen.

12. Schnittstelle für haptische Rückmeldungen (110) nach Anspruch 11, ferner umfassend zusätzliche Wandler für haptische Rückmeldungen, die frei von Luftpumpen sind (111), und Luftkanäle (112) für Luftstrom von mindestens einer der Luftpumpen des einen oder der mehreren Wandler für haptische Rückmeldungen (10),
wobei die Luftkanäle (112) entsprechende Ventile (113) umfassen, die so konfiguriert sind, dass sie den Luftstrom steuern.

13. Schnittstelle für haptische Rückmeldungen nach Anspruch 11 oder Anspruch 12, ferner umfassend eine elektrische Ansteuerschaltung,
wobei die elektrische Ansteuerschaltung so konfiguriert ist, dass sie ein erstes elektrisches EAM-Ansteuersignal an die EAM-Schicht bereitstellt,
wobei die elektrische Ansteuerschaltung so konfiguriert ist, dass sie ein erstes elektrisches Luftpumpen-Ansteuersignal an die Luftpumpe bereitstellt.

14. Schnittstelle für haptische Rückmeldungen nach Anspruch 13, wobei die elektrische Ansteuerschaltung so konfiguriert ist, dass sie Folgendes bereitstellt:
ein zweites elektrisches EAM-Ansteuersignal mit einer Amplitude, die sich von dem ersten elektrischen EAM-Ansteuersignal unterscheidet, und/oder
ein zweites elektrisches Luftpumpen-Ansteuersignal mit einer Amplitude, die sich von dem ersten elektrischen Luftpumpen-Ansteuersignal unterscheidet.

15. Schnittstelle für haptische Rückmeldungen nach Anspruch 13 oder Anspruch 14,
wobei das erste oder das zweite elektrische EAM-Ansteuersignal auf Grundlage einer Ansteuerspannung, Wellenform oder Frequenz des elektrischen EAM-Ansteuersignals modulierbar ist und/oder
wobei das erste oder das zweite elektrische Luftpumpen-Ansteuersignal auf Grundlage einer Ansteuerspannung, Wellenform oder Frequenz des elektrischen Luftpumpen-Ansteuersignals modulierbar ist.

## Revendications

1. Transducteur à rétroaction haptique (10), comprenant :
une membrane en matériau électroactif (EAM) (11) disposée sur un substrat (13), dans lequel la membrane en EAM comprend une couche d'EAM (12) configurée pour fournir une réponse mécanique en réponse à un signal d'excitation électrique ; et
une pompe à air (14) configurée pour commander une pression d'un gaz (15) appliqué sur un côté de la membrane en EAM faisant face au substrat, **caractérisé en ce que** :
le transducteur à rétroaction haptique (10) fournit une rétroaction haptique multi-niveau en modulant le signal d'excitation électrique fourni à la membrane en EAM (11) en association avec la commande de la pression du gaz (15) fourni par la pompe à air (14).

2. Transducteur à rétroaction haptique (10) de la revendication 1, comprenant en outre une couche de couverture élastique (18) disposée sur la membrane en EAM (11).

3. Transducteur à rétroaction haptique (30) de la revendication 1 ou la revendication 2, dans lequel la pompe à air (14) comprend un empilement de micro-soufflantes (16).

4. Transducteur à rétroaction haptique (40) de l'une quelconque des revendications 1 à 3, dans lequel la membrane en EAM comprend une pièce centrale (17) superposée sur la couche d'EAM (12),
dans lequel la pièce centrale (17) est configurée pour être déformable lors de l'application de la pression du gaz (15) appliqué sur la membrane en EAM (11).

5. Transducteur à rétroaction haptique (10) de l'une quelconque des revendications 1 à 4,
dans lequel la couche d'EAM (12) comprend une ou plusieurs fentes (72) fournissant une ouverture à travers une direction d'épaisseur de la couche d'EAM (12), et/ou
dans lequel la couche d'EAM (12) comprend une ou plusieurs fenêtres ouvertes (81) fournissant une ouverture à travers une direction d'épaisseur de la couche d'EAM (12).

6. Transducteur à rétroaction haptique (10) de l'une quelconque des revendications 1 à 5,
dans lequel la couche d'EAM (12) comprend un ou plusieurs évidements (73) à travers une direction d'épaisseur de la couche d'EAM (12).

7. Transducteur à rétroaction haptique (10) de l'une quelconque des revendications 1 à 6,
dans lequel une épaisseur de la couche d'EAM (12) diminue depuis une partie extérieure de la couche d'EAM (64) jusqu'à une partie intérieure de la couche d'EAM (65).

8. Transducteur à rétroaction haptique (10) de la revendication 7, comprenant en outre un dispositif de fixation (90),
dans lequel la couche d'EAM (12) est mécaniquement attachée au substrat (13) par le dispositif de fixation (90).

9. Transducteur à rétroaction haptique (10) de la revendication 8,
dans lequel le dispositif de fixation (90) comprend au moins un d'une goupille, d'un support-rouleau (92), ou d'un ressort ondulé (94), et/ou
dans lequel le dispositif de fixation (90) comprend un composant de serrage de forme concave ou convexe.

10. Transducteur à rétroaction haptique (10) de l'une quelconque des revendications 1 à 9,
dans lequel la couche d'EAM (12) comprend une pluralité de segments (91) s'étendant radialement depuis un centre (62), et
optionnellement, dans lequel les segments (63) sont radialement séparés les uns des autres par une pluralité de découpes.

11. Interface à rétroaction haptique (100), comprenant un transducteur à rétroaction haptique (10) selon l'une quelconque des revendications 1 à 10, ou deux, ou plus, transducteurs à rétroaction haptique (10) selon l'une quelconque des revendications 1 à 10 partageant un substrat commun (130).

12. Interface à rétroaction haptique (110) de la revendication 11, comprenant en outre des transducteurs à rétroaction haptiques supplémentaires qui sont dépourvus de pompe à air (111), et des canaux d'air (112) pour un écoulement d'air depuis au moins une des pompes à air de l'un ou des plusieurs transducteurs à rétroaction haptique (10),
dans laquelle les canaux d'air (112) comprennent des valves respectives (113) configurées pour commander l'écoulement d'air.

13. Interface à rétroaction haptique de la revendication 11 ou la revendication 12, comprenant en outre un circuit d'excitation électrique,
dans laquelle le circuit d'excitation électrique est configuré pour fournir un premier signal d'excitation électrique d'EAM à la couche d'EAM,
dans laquelle le circuit d'excitation électrique est configuré pour fournir un premier signal d'excitation électrique de pompe à air à la pompe à air.

14. Interface à rétroaction haptique de la revendication 13, dans laquelle le circuit d'excitation électrique est configuré pour fournir :
un second signal d'excitation électrique d'EAM ayant une amplitude différente de celle du premier signal d'excitation électrique d'EAM, et/ou
un second signal d'excitation électrique de pompe à air ayant une amplitude différente de celle du premier signal d'excitation électrique de pompe à air.

15. Interface à rétroaction haptique de la revendication 13 ou la revendication 14,
dans laquelle le premier ou le second signal d'excitation électrique d'EAM est modulable sur la base d'une tension, forme d'onde ou fréquence d'excitation du signal d'excitation électrique d'EAM, et/ou
dans laquelle le premier ou le second signal d'excitation électrique de pompe à air est modulable sur la base d'une tension, forme d'onde ou fréquence d'excitation de la signal d'excitation électrique de pompe à air.
